# EUROPEAN PATENT SPECIFICATION

(11) **EP 2 432 130 B1**
(45) Date of publication and mention of the grant of the patent: **08.07.2015**
(21) Application number: 11151393.3
(22) Date of filing: 19.01.2011
(51) Int. Cl.: H04B 1/04, H04B 1/00

(54) **SAW filter-less transmitter architecture**
Senderarchitektur ohne SAW Filter
Architecture de transmetteurs sans filtres SAW

(30) Priority: 13.09.2010 US 382292 P
(43) Date of publication of application: 21.03.2012
(73) Proprietor: IMEC, 3001 Leuven (BE); Renesas Electronics Corporation, Kawasaki-shi, Kanagawa (JP)
(72) Inventor: Giannini, Vito, 72023 Mesagne (IT); Sano, Tomohiro, Itami-city Hyogo 664-0006 (JP); Ingels, Mark, 3370, Boutersem (BE); Craninckx, Jan, 3370, Boutersem (BE)
(74) Representative: Mackett, Margaret Dawn

(56) References cited:
- US-A1- 2004 209 591
- US-A1- 2010 022 215

## Description

The present invention relates to wireless transmitters and is more particularly concerned with such transmitters utilising sawless transmitter architecture.

Wireless communications are categorised into FDD (frequency division duplexing) and TDD (time division duplexing). In FDD systems, transmitter and receiver operate simultaneously but at different frequencies while the duplexer provides isolation between them. Due to the finite duplexer transmitter-receiver isolation, out-of-band noise present in the transmitter is especially critical as it leaks into the receiver band irreparably corrupting the sensitivity of the receiver. Far-out-of-band noise is an important concern in transmitting devices when they coexist with standards like Global Positioning System (GPS), Wireless Local Area Network (WLAN) and/or Worldwide Interoperability for Microwave Access (WiMAX) on the same smartphone.

Typically, an inter-stage Surface Acoustic Wave (SAW) filter is added to suppress this transmitter leakage with an inter-stage SAW filter being required for every band between Pre-Power Amplifier (PPA) and Power Amplifier (PA). This severely increases the cost of materials required and the footprint of the overall device.

When Carrier-to-Noise (CNR) values at different RX frequency offset are lower than -160dBc/Hz at the PPA output (example of worst case value for current application), it is possible to remove the inter-stage SAW. A conventional voltage-sampling mixing transmitter is described in an article by M. Ingels, V. Giannini, J. Borremans, et al., entitled "A 5mm2 40nm LP CMOS 0.1-to-3GHz Multistandard Transceiver", ISSCC Dig. Tech. Papers, pp.458-459, Feb. 2010. An active filter is needed to remove the Digital-to-Analogue Conversion (DAC) aliases to reconstruct the wanted signal. Furthermore, a passive pole (RP-CP) is still needed to further reduce the out-of-band noise before a voltage-sampling mixer up-converts the signal to RF. However, by introducing such passive pole, several issues will arise:
1) The passive mixing operation will suffer increased gain losses and therefore reduction of P1 dB over the RF frequency;
2) Being a fixed passive pole, there are no trade-offs available in case different RX FDD frequency offsets should be targeted;
3) As the Passive-Pole introduces noise by itself too, different trade-offs might be needed when the target channel bandwidths are different.

In "A Low-Power, Low-EVM, SAW-Less WCDMA Transmitter Using Direct Quadrature Voltage Modulation" by Xin He and Jan van Sinderen, IEEE J. Solid-State Circuits, Vol. 44, No. 12, December 2009, a transmitter is described that used direct quadrature voltage modulation. The core of the modulator is a passive voltage mixer driven by a 25% duty-cycle local oscillator which provides significantly improved performance in terms of output noise, linearity, Local Oscillator (LO) leakage, Error Vector Magnitude (EVM) and power consumption in the transmitter. Here, the requirement to accommodate standard diversities among different countries and different operation service providers is noted in that next generation mobile handsets will need to support up to 10 Wideband Code Division Multiple Access (WCDMA) bands (Bands I, II, III, IV, V, VI, VIII, IX, X and XI), 4 Global System for Mobile communications (GSM)/Enhanced Data rates for GSM Evolution (EDGE) bands (Bands GSM850, EGMS900, DCS1800 and PCS1900), as well as the emerging standard Long Term Evolution (LTE).

One of the key challenges to the elimination of SAW filters between the transmitter and PA is to achieve low transmitter noise floor without sacrificing power consumption. A new passive voltage mixer is described that leads to improved performance in terms of power consumption, noise floor, linearity, LO leakage and EVM. The direct quadrature voltage modulator consists of a Low Pass Filter (LPF), mixer and PA driver. The LPF attenuates the far-out noise at the proceeding Intermediate Frequency (IF) input and also suppresses the aliases from the DAC. By switching on/off four transistors through the quadrature-phased LO with the 25% duty-cycle, the filtered IF quadrature input voltages are sequentially sampled to the voltage mixer output which sees the high input impedance of the PA driver. Due to the high input impedance of the PA driver that employs a cascode structure, the linearity of the voltage mixer is not degraded.

However, due to the 25% duty-cycle LO waveforms, the slope of the rising edges and the falling edges cannot be infinite. The switch-on and switch-off time in the mixer switches cannot be zero. These effects result in a short overlapping period during the transition between just turning off one transistor and just turning on the next which degrades the linearity of the passive voltage mixer.

The out-of-band noise problem has been extensively analysed for the most popular WCDMA bands (I, II, V). CMOS transmitters with receiver band CNR down to -160dBc/Hz, as described above, also include the replacement of high-voltage Gilbert mixers (as described by M. Cassia et al. in "A Low-Power CMOS SAW-Less Quad Band WCDMA/HSPA/HSPA+/1X/EGPRS Transmitter", IEEE. J. Solid-State Circuits, vol. 44, no. 7, pp 1897-1906, July 2009, and by C Jones et al. in "Direct-Conversion WCDMA Transmitter with 163dBc/Hz Noise at 190MHz Offset", ISSCC Dig. Tech. Papers, pp. 336-607, Feb. 2007) as they are generally power hungry. Feedback-based notching techniques, as described by A. Mirzaei and H. Darabi in "A Low-Power WCDMA Transmitter with an Integrated Notch Filter", IEEE J. Solid-State Circuits, vol. 43, no. 12, pp. 2868-2881, Dec. 2008, might impact the achievable output power when wider bandwidths and low transmitter-receiver offsets are required.

A direct quadrature voltage modulator has been proposed in an article by Xin He, Jan van Sinderen and Robert Rutten, entitled "A 45nm WCDMA Transmitter Using Direct Quadrature Voltage Modulator with High Oversampling Digital Front-End", ISSCC Dig. of Tech. Papers, pp. 62-63, Feb. 2010. A highly digitised multimode transmitter is described in which a Direct Quadrature Voltage Modulator (DQVM) incorporates the high speed DAC and Digital Front-End (DFE) with high oversampling ratio capable of multimode operation by adapting the sampling data rate. In the DFE, the serial I/Q baseband inputs are first converted to parallel 10-bit or 12-bit I/Q data and then are upsampled to 32x, the input data rate before feeding the DAC. This up-conversion technique uses the combination of an RC pole and passive mixer to achieve both linearity and low out-of-band noise. However, losses in such a mixer are proportional to the resistor value and, especially at high carrier frequencies; they shift the linearity requirements to the baseband driving stage large linear signal swings must be provided on a low impedance node.

In the architecture described, a simple passive LPF after the DAC is sufficient to suppress the sampling images with the help of a high oversampling ratio. The advantage of using a high oversampling ratio in the DFE rather than an active LPF after the DAC is that the power and the area can be reduced with CMOS scaling. The I/Q matching is also improved. Moreover, it can be easily adapted to different standards by using different sampling clock frequency and bypass mode settings.

Moreover, the challenge of SAW-less receiver band noise becomes more acute in the LTE standard (3GPP TS 36.101, "Evolved Universal Terrestrial Radio Access (LTE): User Equipment (UE) Radio Transmission and Reception", v. 8.6.0, June 2009) where transmitters are needed to operate in multiple FDD bands using wider channel bandwidths and higher Peak-to-Average Power Ratios (PAPR).

US-A-2010/0022215 discloses a SAW-less bandpass filter for use in wireless communications devices in which noise gain produced by an operational amplifier is attenuated. The bandpass filter comprises at least one pole circuit and feedback loops. Capacitive feedback loops are provided to compensate for the phase shift applied to the signal by the pole circuit, to control the stability of the filter and to improve the phase margin and closed loop response. An additional resistive feedback loop is also provided to scale the signal that is fed back to the input of the operational amplifier.

US-A-2004/0209591 discloses a reconfigurable baseband filter for use in a multi-mode communication system. An input resistor and a feedback resistor are configured as a plurality of switchable subelements at least two of which are electrically connected in parallel to reduce switching noise.

It is therefore an object of the present invention to provide a wireless (multi-standard) transmitter core using passive pole filtering.

In accordance with a first aspect of the present invention, there is provided a transmitter circuit comprising:- an active filter/amplifier arrangement connected to receive an input signal; and a passive filtering arrangement connected to receive an output signal of the active filter/amplifier arrangement; at least one feedback loop connecting the passive filtering arrangement to the input signal of the active filter/amplifier arrangement, the feedback loop being tapped from the passive filtering arrangement; characterised in that each feedback loop includes a feedback loop resistance element; and in that the passive filtering arrangement comprises at least two switchable resistance elements, the resistance elements in the passive filtering arrangement forming a passive pole arrangement with a capacitance element connected across the resistance elements.

The transmitter circuit in accordance with the present invention has the advantage that it suppresses noise generated by the active filter/amplifier arrangement using the passive filtering arrangement by feeding back a signal generated by the passive filtering arrangement to the input of the active filter/amplifier arrangement.

Whilst a passive pole arrangement is described above in relation to the prior art, the passive pole arrangement preferably comprises an array of switchable resistance elements, the capacitance element being connected across all switchable resistance elements in the array to form the passive pole arrangement with active resistance elements. Here, the passive pole arrangement becomes variable as the resistance elements are switched in accordance with the values required.

In this way, the filtering is flexible due to the use of switchable resistors inside a feedback loop of an amplifier or an active filtering stage.

In addition, each feedback loop resistance element may also comprise a switchable resistance element. Each switchable resistance element comprises a switch element and at least one resistance element.

Preferably, the transmitter circuit forms part of a transceiver circuit with substantially reduced out-of-band noise in the receiver circuit thereof. Ideally, the transceiver circuit is formed as an integrated circuit together with other components necessary for the operation of the transceiver.

In one embodiment, an integrated circuit arranged for generating a baseband signal having low RX-band noise may be provided. The circuit comprises an active filtering/amplifier means arranged for generating a first filtered baseband signal of an input signal (operating at baseband), at least one feedback loop comprising a flexible resistor and/or a switch and a passive filtering means arranged for suppressing noise in the first filtered baseband signal.

The passive filtering means comprises at least one flexible resistor, and the passive filtering means is connected via the at least one feedback loop with the input of the active filtering/amplifier means thereby removing/reducing the non-linearity of the at least one flexible resistor. The integrated circuit may further comprise mixing means arranged for up-converting the baseband signal to an RF signal with low RX band noise.

In an embodiment, an additional passive filtering means comprises a plurality of flexible switchable resistors connected to the output of a first filtering means.

In an alternative embodiment, a method is described for generating an amplified baseband having low receiver-band noise comprising the steps of generating a first filtered baseband of an input signal by means of an active filtering/amplifier, suppressing noise in the first filtered baseband signal by means of at least one passive filtering means, and removing/reducing the non-linearity of the at least one flexible resistor by providing an at least one feedback loop connecting the at least one passive filtering means to the input of the active filtering/amplifier.

For a better understanding of the present invention, reference will now be made, by way of example only, to the accompanying drawings in which:-
Figure 1 illustrates a block diagram of a conventional transceiver arrangement;
Figure 2 illustrates a block diagram of a conventional transmitter;
Figure 3 illustrates a block diagram of a circuit in accordance with the present invention;
Figure 4 illustrates a block diagram of a transmitter in accordance with a first embodiment of the present invention;
Figure 5 illustrates a block diagram of a transmitter in accordance with a second embodiment of the present invention;
Figure 6 is similar to Figure 5 but illustrates one possible switching arrangement of the present invention; and
Figure 7 is similar to Figure 5 but illustrates another possible switching arrangement of the present invention.

The present invention will be described with respect to particular embodiments and with reference to certain drawings but the invention is not limited thereto. The drawings described are only schematic and are non-limiting. In the drawings, the size of some of the elements may be exaggerated and not drawn on scale for illustrative purposes.

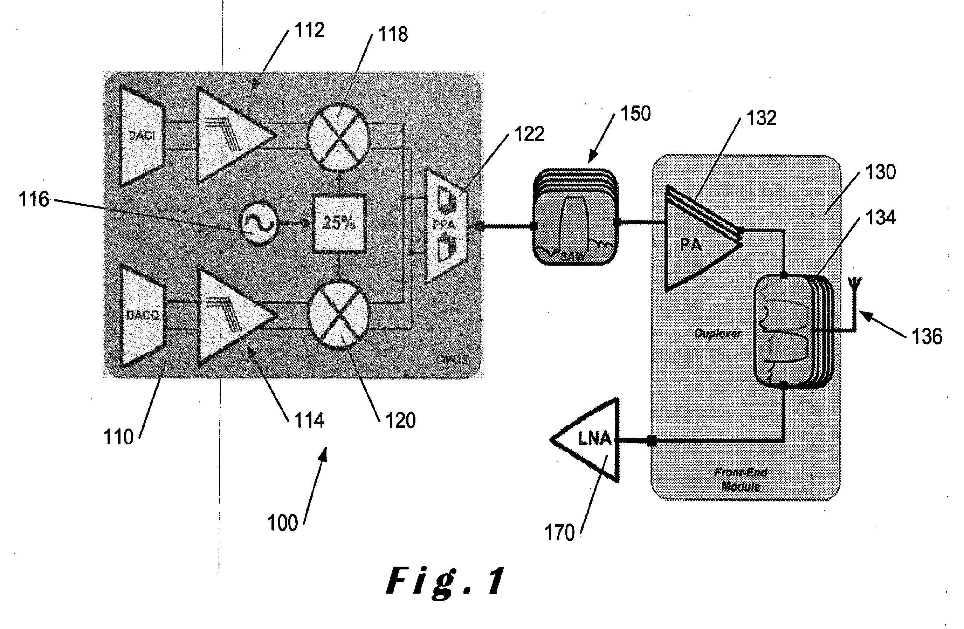

Referring initially to Figure 1, a block diagram illustrating a transceiver 100 where an inter-stage surface acoustic wave (SAW) filter has been added to suppress transmitter leakage as discussed above. The transceiver 100 comprises a transmitter stage 110 and a front end module 130 connected by means of a SAW filter 150. The front end module 130 includes a power amplifier (PA) 132, a duplexer 134 and an antenna 136. As shown, the antenna 136 is connected to the duplexer 134 so that the transmitter and receiver functions of the transceiver 100 can be interleaved in an appropriate manner. The duplexer 134 is also connected to a low noise amplifier (LNA) 170 that forms an input to a receiver stage (not shown).

The transmitter stage 110 comprises baseband channels as indicated by arrows 112, 114 that are mixed with signals from a local oscillator (LO) 116 in respective mixers 118, 120 prior to being amplified in a pre-power amplifier (PPA) 122. The LO 116 operates on a 25% duty cycle. Output signals 124 from the PPA 122 form the input to the SAW filter 150.

The transmitter stage 110 can be implemented using complementary metal-oxide semiconductor (CMOS) technology on a single integrated circuit.

As shown in Figure 1, the SAW filter 150 effectively comprises a bank of filter elements, where each filter element is required for a particular frequency band. The PA 132 and duplexer 134 each comprise a bank of elements that are designated for particular frequency bands.

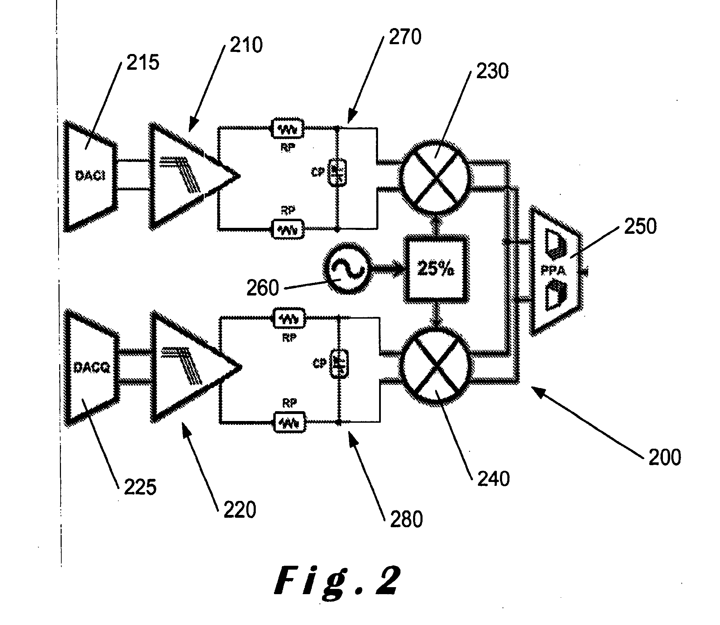

In Figure 2, a conventional voltage-sampling mixing transmitter 200 is shown. Such a transmitter is described in the article entitled "A 5mm² 40nm LP CMOS 0.1-to-3GHz Multistandard Transceiver" discussed above. The transmitter 200 comprises baseband channels 210, 220 that feed mixers 230, 240 prior to being passed to a PPA 250. A LO 260 supplies mixing signals for the mixers 230, 240 as shown on a 25% duty cycle.

In addition, a passive pole (RP-CP) 270 is located in the baseband channel 210 between a digital-to-analogue converter (DACI) 215 and the mixer 230. Similarly, in the baseband channel 220, an identical passive pole (RP-CP) 280 is located between a digital-to-analogue converter (DACQ) 225 and the mixer 240.

However, as discussed above, there are disadvantages with introducing such passive poles. Gain losses are increased and there are no trade-offs in different frequency offsets. In addition, the passive-pole itself introduces noise.

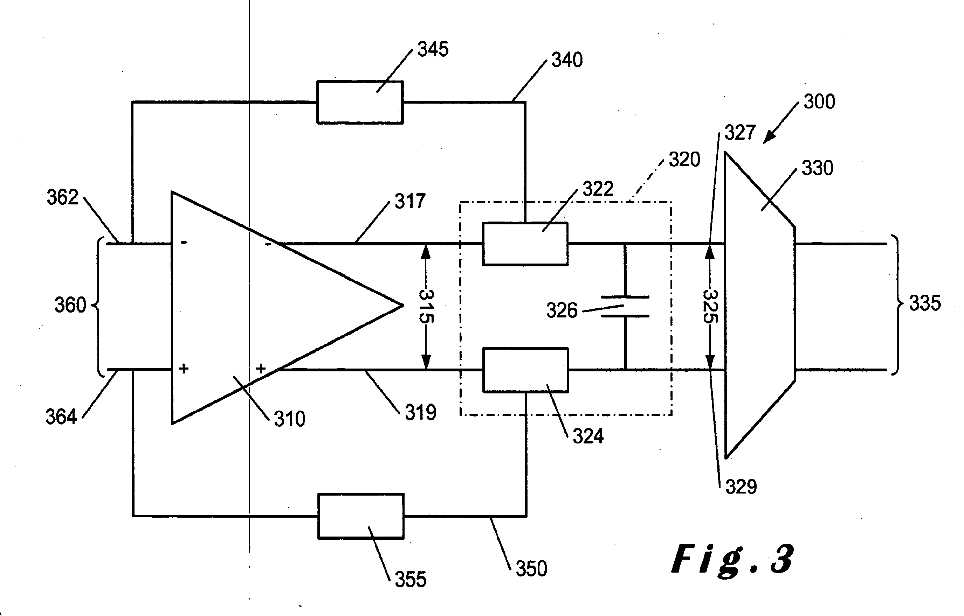

The present invention relates to a wireless (multi-standard) transmitter core that uses flexible passive pole filtering. The flexibility is provided by a switchable resistance element inside a feedback loop of an amplifier or active filtering stage. The principle of operation is described with reference to Figure 3.

In Figure 3, a simplified transmitter circuit 300 for one baseband channel in accordance with the present invention is shown. The circuit 300 comprises an active filter/amplifier 310 connected to a passive filter arrangement 320. The passive filter arrangement 320 is connected to a PPA 330 and to the active filter/amplifier 310 by two feedback loops 340, 350. Output signal 335 from the PPA 330 is passed to a front end (not shown) for transmission.

Input signal 360, shown as negative line 362 and positive line 364, from a DAC (not shown) is input to the positive and negative terminals of the active filter/amplifier 310. An output signal 315, shown as negative line 317 and positive line 319, from the active filter/amplifier 310 is input to the passive filter arrangement 320 as shown. An output signal 325, shown as negative line 327 and positive line 329, from the passive filter arrangement 320 is passed to a PPA 330 as shown.

Whilst the transmitter circuit shown in Figure 3 is a differential circuit, it will readily be appreciated that the present invention can also be used with a single-ended circuit. In this case, a single feedback loop will be provided from the single output of the passive filter arrangement to the single input of the active filter/amplifier.

The passive filter arrangement 320 comprises two resistance elements 322, 324 and a capacitance element 326 connected across the two resistance elements 322, 324 as shown. Each line 317, 319 of output signal 315 provided by active filter/amplifier 310 is connected to a respective one of the resistance elements 322, 324.

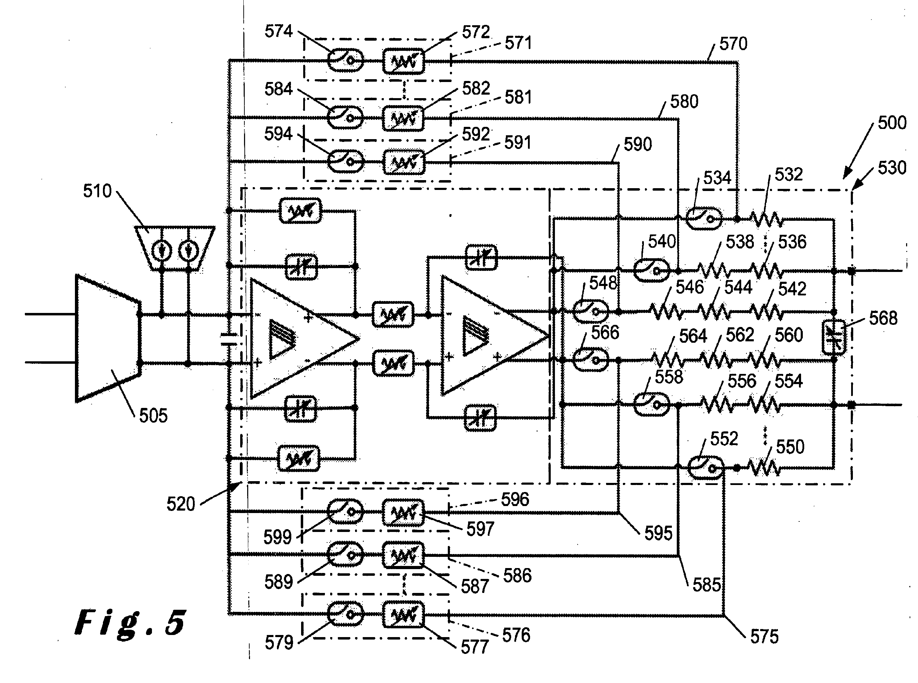

Feedback loop 340 comprises a tap from the resistance element 322 that is fed back to the negative line 362 of input signal 360. Feedback loop 340 also includes a resistance element 345. Similarly, feedback loop 350 comprises a tap from the resistance element 324 that is fed back to the positive line 364 of input signal 360 and includes a resistance element 355. Here, each resistance element 322, 324 effectively comprises a switch element and a resistor element and the tap is taken between the switch element and the resistor element (shown more clearly in Figure 5).

Elements 322, 324, 345 and 355, although described as resistance elements, may take any suitable form to provide the function of the passive pole arrangement and the feedback loops and may include at least one switch element (not shown).

The passive filter arrangement 320 is arranged for suppressing noise in the baseband signal 360 where the feedback loops 340, 350 remove or reduce the non-linearity of the variable resistance elements 322, 324.

It will be appreciated that Figure 3 is simplified for ease of explanation by referring to a single baseband signal. However, it will readily be understood that an identical configuration can be provided for each baseband signal if an I-Q arrangement is implemented. Moreover, a multi-standard transmitter is a multi-mode and multi-band transmitter in which a signal path can be reused for different modes and bands. In accordance with the present invention, a (multi-standard) transmitter architecture can be provided without performance degradation and which has the ability to trade-off mixer gain losses for out-of-band noise where necessary.

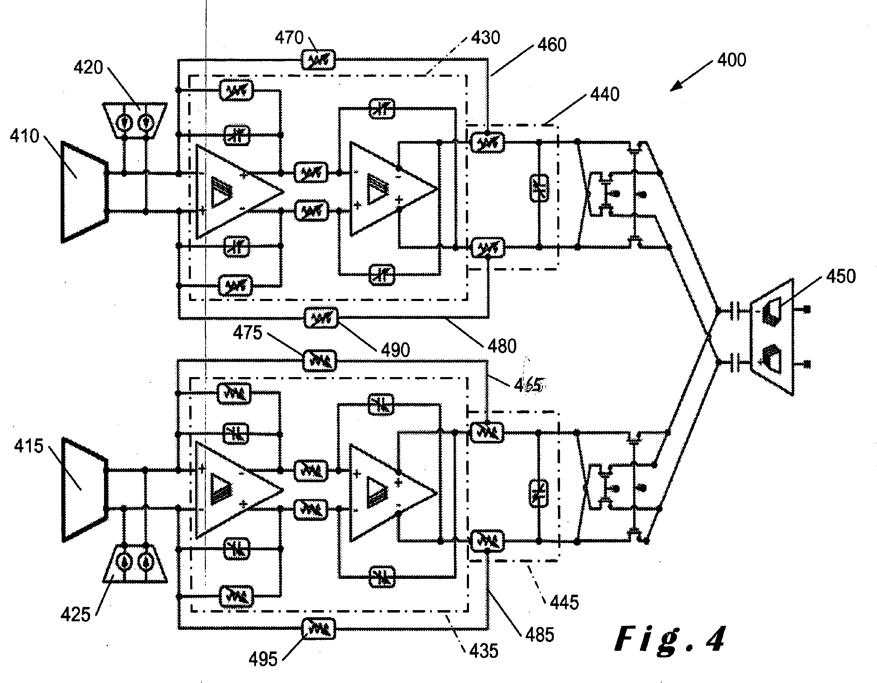

Figure 4 illustrates a block diagram of a transmitter 400 in accordance with the present invention. Here, resistance elements in the feedback loop are switchable making the architecture more flexible. Ideally, the switches are in the feedback loop of the previous active filtering stage.

For each baseband channel, the transmitter 400 comprises DACI 410 and DACQ 415; digitally-controlled oscillators (DCO) 420, 425; active filter/amplifiers 430, 435; passive filter arrangements 440, 445; PPA 450; and feedback loops 460, 465, 480, 485 with their switchable resistance elements 470, 475, 490, 495. Although described in terms of baseband channels, it will be appreciated that it can be the signal or signal component in the I-Q situation that passes through the components listed above.

In the transmitter described in Figure 4, it is possible to solve the problem of carrier-to-noise (CNR) in frequency division duplexing (FDD) for long term evolution (LTE). transmitters that have 15 bands and 6 bandwidths.

This arrangement provides the following advantages:-
1) The non-linearity in the resistance of the RP switches is now divided by the open-loop gain of the feedback based active filter making their contribution to the output distortion negligible;
2) Ideally, any RP value can be selected allowing trade-offs that would require a big RP value, that is, when very close receiver offsets are required such as 30MHz and 48MHz, and the ones where the RP should be as small as possible, that is, wide channel bandwidth and high radio frequency (RF). In practice, the RP values are limited to a predetermined number of combinations in order to minimise the complexity of the system; and
3) The active filter operational amplifier noise specifications can be relaxed as well as power consumption as out-of-band noise can be effectively and efficiently filtered in each band/bandwidth setting.

Figure 5 illustrates another transmitter arrangement in accordance with the present invention. Here, a single baseband channel 500 is shown for clarity, but it will be appreciated that, in an operational transmitter, there may be two of these channels 500, one for the I channel and one for the Q channel. As mentioned above, these channels may be signals or signal components.

In a similar way to the transmitter described with reference to Figure 4, the baseband channel 500 comprises a DAC 505; a DCO 510; an active filter/amplifier 520 shown as a dotted block containing filtering and/or amplifying elements; a passive filter arrangement 530; and feedback loops 570, 575, 580, 585, 590, 595.

Here, the passive filter arrangement 530 comprises a plurality of resistance elements that are configurable to receive the output from the active filter/amplifier 520 by means of switch elements. Although only three rows of resistance elements and their associated switch elements are shown for each of the lines forming the output of the active filter/amplifier 520, it will be appreciated that any number of rows of resistance elements and their associated switch elements can be provided in accordance with the particular application. Here, one row of resistance elements and their associated switch elements corresponds to one frequency band.

As shown, for the negative line output from the active filter/amplifier 520, there is a resistance element 532 associated with a switch element 534; a pair of resistance elements 536, 538 connected in series associated with a switch element 540; and three resistance elements 542, 544, 546 connected in series associated with a switch element 548. Similarly, for the positive line output from the active filter/amplifier 520, there is a resistance element 550 associated with a switch element 552; a pair of resistance elements 554, 556 connected in series associated with a switch element 558; and three resistance elements 560, 562, 564 connected in series associated with a switch element 566. As before, a capacitance element 568 is connected across the resistance elements as shown, and, according to which switches are closed, forms a variable passive pole arrangement with relevant resistance elements.

Each switch and associated resistance element or elements can be considered to be a resistance pole, and together, each switch and associated resistance element or elements can be considered to form part of a resistance pole array.

Turning now to the feedback loops, each feedback loop 570, 575, 580, 585, 590, 595 includes a switchable resistance element 571, 576, 581, 586, 591, 596. As shown, each switchable resistance element 571, 576, 581, 586, 591, 596 comprises a respective resistance element 572, 577, 582, 587, 592, 597 and switch element 574, 579, 584, 589, 594, 599.

In operation, the switch elements 534, 540, 548, 552, 558, 566 in the passive filter arrangement 530 are closed to activate their associated resistance elements. Similarly, the switch elements 574, 579, 584, 589, 594, 599 in the switchable resistance elements 571, 576, 581, 586, 591, 596 in the feedback loops 570, 575, 580, 585, 590, 595 are also closed to activate their associated resistance elements 572, 577, 582, 587, 592, 597.

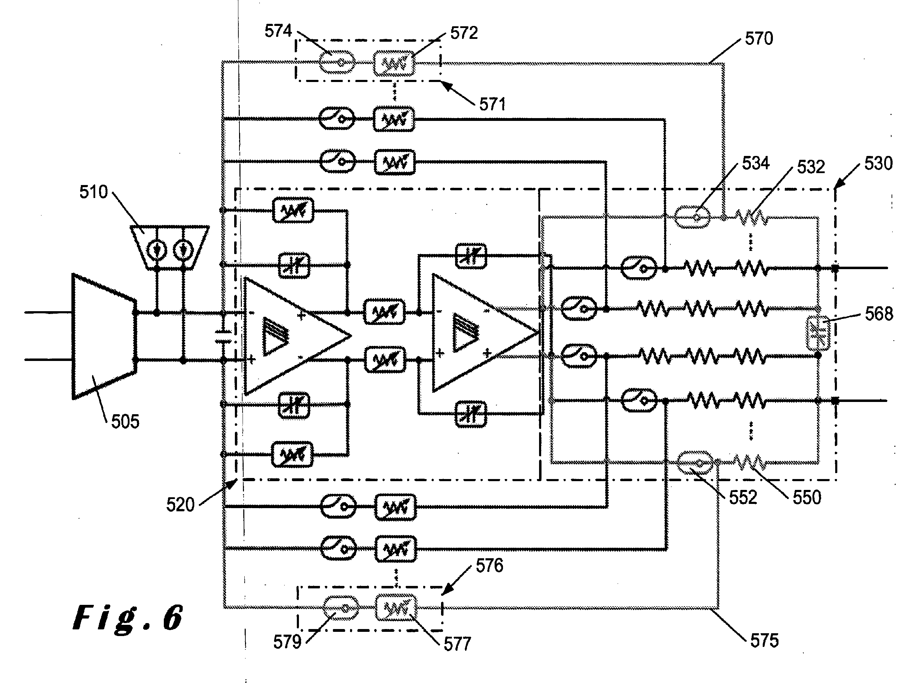

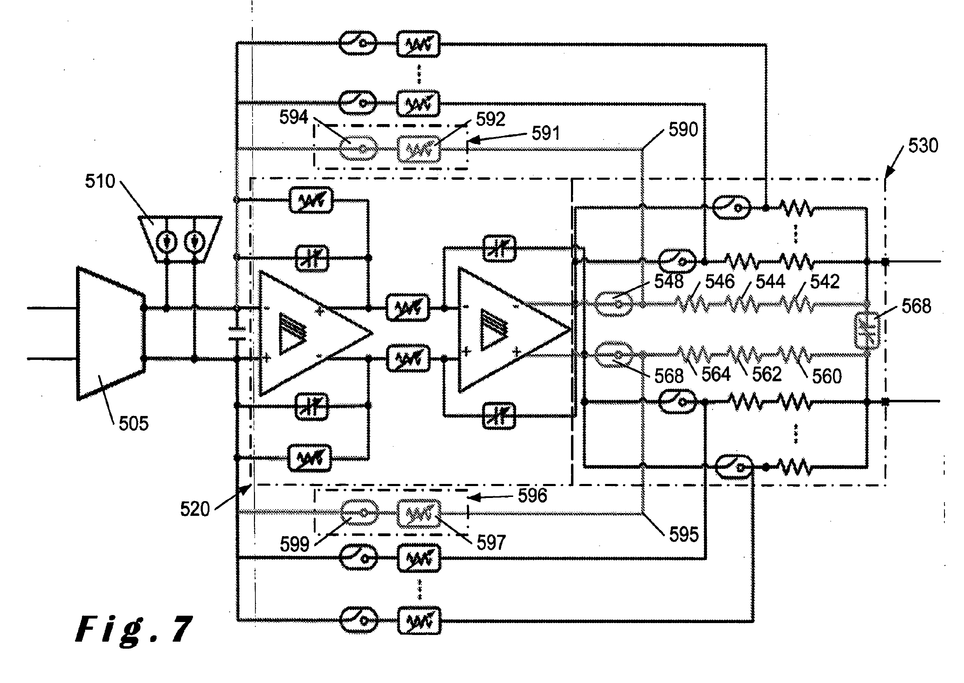

In the arrangement shown, pairs of switch elements in the passive filter arrangement 530 operate with pairs of switch elements in the feedback loops. For example, switch elements 534 and 552 in the passive filter arrangement 530 operate with switch elements 574 and 579 in respective feedback loops 570 and 575. Similarly, switch elements 540 and 558 operate with switch elements 584 and 589 and switch elements 548 and 566 operate with switch elements 594 and 599. This is described in more detail with reference to Figures 6 and 7 below.

Figures 6 and 7 illustrate the selection of the resistance elements. Components that have been described with reference to Figure 5 above have the same reference numerals.

In Figure 6, a pair resistance poles, each having a single resistance element, is to be selected in the passive filter arrangement 530. Switch elements 534 and 552 associated with respective resistance poles are closed to create an active circuit that includes resistance element 532 to form one resistance pole and resistance element 550 to form the other resistance pole. Capacitance element 568 completes the active passive filtering circuit. The associated feedback loops 570, 575 are also activated by closure of switch elements 574 and 579.

Similarly, in Figure 7, a pair of resistance poles, each having three resistance elements, is to be selected in the passive filter arrangement 530. Switch elements 548 and 568 are closed to create an active circuit that includes resistance elements 542, 544, 546 to form one resistance pole and resistance elements 560, 562, 564 to form the other resistance pole. Capacitance element 568 completes the active passive filtering circuit. The associated feedback loops 590, 595 are also activated by the closure of switch elements 594 and 599.

Whilst the resistance elements in the passive filter arrangement 530 are shown as being single resistors, it will be appreciated that they may comprise multiple resistors connected to provide any desired resistance value.

In an example of the present invention, a complete transmitter chain can be provided that covers all 17 LTE bands and beyond, resulting in a highly efficient and flexible transmitter. Such a transmitter may achieve CNR down to -162dBc/Hz for channel bandwidths up to 20MHz in most LTE/FDD bands, including band XI (1.4GHz carrier/48MHz transmitter-receiver distance), band XII (0.7GHz/30MHz) and band VII (2.5GHz/120MHz), without the aid of external inter-stage acoustic filters. Furthermore, the same transmitter may be used in legacy WCDMA FDD scenarios and can be used with other bands/modulations such as Gaussian Minimum Shift Keying (GMSK) and Orthogonal Frequency Division Multiplexing (OFDM)-based standards up to 5.5GHz carrier frequency.

The transmitter may use a flexible 3^{rd} order trans-impedance low-pass filter (TILPF) to remove DAC aliases and out-of-band quantisation noise. In this case, the TILPF may be followed by a passive mixer which up-converts the baseband voltage onto the pre-power amplifier's (PPA) input capacitor. To ease the interfacing with different power amplifiers, two on-chip baluns centred around 1 GHz and 2GHz may be integrated within the transmitter and a wideband differential output extends the transmission frequency range.

The TILPF may be based on a flexible Tow-Thomas topology that offers independent programming of trans-impedance gain and bandwidth whereas a quadrature voltage sampling mixer passively performs up-conversion using a low-noise 25% duty-cycle LO driver.

Filtering and mixing stages may be designed to limit the impact on CNR while keeping the power consumption minimal over all the required RF range. At baseband, in order to achieve out-of-band noise lower than -180dBV/Hz with limited power consumption, an additional passive filtering stage may be added after the TILPF.

In the example above, good CNR and sufficient output power over different bands can be achieved with a tuneable passive pole arrangement as described above. However, special care must be taken in selecting the right resistance pole (RP) value which finally determines the losses of the passive mixer and therefore the transmitter maximum frequency range. Low cut-offs and big RP values are an option when the selected band foresees transmission-reception frequency offset lower than 48MHz at lower RF frequencies; on the other hand, RP should be as small as possible when wide channel bandwidth and high RF frequency are required.

As described above with reference to Figures 6 and 7, the switches of the RP array are closed inside a multi-feedback loop generated from the previous filtering stage. When a switch in the passive filter arrangement, a passive switch, is ON to activate a certain resistance element, a correspondent feedback loop is selected through a feedback switch. The non-linear resistance of the active passive switch is thus divided by the open loop gain of the TILPF making its contribution to the distortion negligible. Overall the passive pole bandwidth can vary from about 7MHz to 50MHz without sacrificing linearity. In order to efficiently drive resistance element values as low as 40Ω, a class-AB low-voltage op-amp topology is implemented that can trade power consumption for linearity where needed.

A PPA may consist of a cascoded differential Common Source amplifier loaded with two on-chip baluns with programmable centre frequency. A differential wide-band output may be provided to extend the frequency range. The amplifier transistor may be split in binary scaled units that can be turned on or off by thick-oxide cascode transistors. At the low end, additional gain steps are obtained by dumping the cascode output current either to the correct output or the power supply. Overall, the PPA gain range is 60dB achieved in eleven coarse steps of 6dB. Fine tuning is also available to achieve less than 1dB gain control.

A comparison with state-of-the-art SAW-less cellular transmitters is shown in Table 1 below for WCDMA band1. This table demonstrates that a transmitter in accordance with the present invention, although very flexible, does not pay a price in performance compared to dedicated ones.

**Table 1.**

| | **'A'** | **'B'** | **'C'** | **'D'** | **'E'** | **'F'** |
|---|---|---|---|---|---|---|
| **CMOS [NM]** | 180 | 180 | 65 | 45 | 90 | 40 |
| **AREA [MM²]** | 5 | 4.5 | 0.2 | 0.8 | N.R. | 0.98 |
| **POUT [DBM]** | +5 | +3.8 | +3.3 | +1 | +2 | +3.79 |
| **ACLR [DB]** | -42.6 | -46 | -44 | -49 | -50 | -40.6 |
| **CNR [DBC/Hz]** | 160-3* | -158 | -160 | -158 | -159.8 | -161 |
| **DELTA [MHz]** | 190 | 40 | 80 | 240 | 190 | 40 |
| **EVM [%]** | 4.7% | 3.7% | 4.5% | 2% | 2% | 2% |
| **PDC [MW]** | 72-118 | 75-210 | 65 (NO PLL) | 27 (NO PLL) | 158-342 (@ BATTERY) | 23-125 (NO PLL) |

In Table 1, 'F' refers to a transmitter arrangement in accordance with the present invention. The others refer to arrangements described in the prior art documents as discussed above:-
'A' refers to M. Cassia et al. in "A Low-Power CMOS SAW-Less Quad Band WCDMA/HSPA/HSPA+/1X/EGPRS Transmitter", IEEE. J. Solid-State Circuits, vol. 44, no. 7, pp 1897-1906, July 2009
'B' refers to C Jones et al. in "Direct-Conversion WCDMA Transmitter with 163dBc/Hz Noise at 190MHz Offset", ISSCC Dig. Tech. Papers, pp. 336-607, Feb. 2007
'C' refers to A. Mirzaei and H. Darabi in "A Low-Power WCDMA Transmitter with an Integrated Notch Filter", IEEE J. Solid-State Circuits, vol. 43, no. 12, pp. 2868-2881, Dec. 2008
'D' refers to Xin He, Jan van Sinderen and Robert Rutten, entitled "A 45nm WCDMA Transmitter Using Direct Quadrature Voltage Modulator with High Oversampling Digital Front-End", ISSCC Dig. of Tech. Papers, pp. 62-63, Feb. 2010
'E' refers to K Hausmann et al., "A SAW-less CMOS TX for EGPRS and WCDMA", IEEE Radio Frequency Integrated Circuits Symposium (RFIC), pp. 25-28, May 2010, in which a 90nm CMOS TX path architected for operation without inter-stage SAW filters is described in which the SAW elimination strategy is purely low noise design but the architecture still achieves DG.09 weighted TX current drain of 50mA from the battery. The combination of a passive interleaved switching mixer plus digital gain control allows 2% EVM at 2dBm and 4.2% at -78dBm.

## Claims

1. A transmitter circuit (300; 400; 500) comprising:-
an active filter/amplifier arrangement (310; 430, 435; 520) connected to receive an input signal (360, 362, 364); and
a passive filtering arrangement (320; 440, 445; 530) connected to receive an output signal of the active filter/amplifier arrangement (310; 430, 435; 520);
at least one feedback loop (340, 350; 460, 465, 480, 485; 570, 575, 580, 585, 590, 595) connecting the passive filtering arrangement (320; 440, 445; 530) to the input signal (360, 362, 364) of the active filter/amplifier arrangement (310; 430, 435; 520), the feedback loop (340, 350; 460, 465, 480, 485; 570, 575, 580, 585, 590, 595) being tapped from the passive filtering arrangement (320; 440, 445; 530);
**characterised in that** each feedback loop (340, 350; 460, 465, 480, 485; 570, 575, 580, 585, 590, 595) includes a feedback loop resistance element (345, 355; 470, 475, 490, 495; 571, 576, 581, 586, 591, 596);
and **in that** the passive filtering arrangement (320; 440, 445; 530) comprises at least two switchable resistance elements (322, 324; 532, 534, 536, 538, 540, 542, 544, 546, 548, 550, 552, 554, 556, 558, 560, 562, 564, 566), the resistance elements (322, 324; 532, 534, 536, 538, 540, 542, 544, 546, 548, 550, 552, 554, 556, 558, 560, 562, 564, 566) in the passive filtering arrangement (320; 440, 445; 530) forming a passive pole arrangement with a capacitance element (326; 568) connected across the resistance elements (322, 324; 532, 534, 536, 538, 540, 542, 544, 546, 548, 550, 552, 554, 556, 558, 560, 562, 564, 566).

2. A transmitter circuit according to claim 1, wherein the passive filtering arrangement (530) comprises an array of switchable resistance elements (532, 534, 536, 538, 540, 542, 544, 546, 548, 550, 552, 554, 556, 558, 560, 562, 564, 566), the capacitance element (568) being connected across all switchable resistance elements (532, 534, 536, 538, 540, 542, 544, 546, 548, 550, 552, 554, 556, 558, 560, 562, 564, 566) in the array to form the passive pole arrangement with active resistance elements.

3. A transmitter circuit according to claim 1 or 2, wherein each feedback loop resistance element (345, 355; 470, 475, 490, 495; 571, 576, 581, 586, 591, 596) comprises a switchable resistance element.

4. A transmitter circuit according to claim 2 or 3, wherein each switchable resistance element (345, 355; 470, 475, 490, 495; 532, 534, 536, 538, 540, 542, 544, 546, 548, 550, 552, 554, 556, 558, 560, 562, 564, 566, 571, 576, 581, 586, 591, 596) comprises a switch element (534, 540, 548, 552, 558, 566, 574, 579, 584, 589, 594, 599) and at least one resistance element (532, 536, 538, 542, 544, 546, 550, 554, 556, 560, 562, 564, 574, 579, 584, 589, 594, 599).

5. A transmitter circuit according to any one of the preceding claims, wherein the transmitter circuit forms part of a transceiver circuit.

6. An integrated circuit including a transceiver according to claim 5.

## Patentansprüche

1. Senderschaltung (300; 400; 500), die Folgendes umfasst:
eine aktive Filter/Verstärker-Anordnung (310; 430, 435; 520), die verbunden ist, um ein Eingangssignal (360, 362, 364) zu empfangen; und
eine passive Filterungsanordnung (320; 440, 445; 530), die verbunden ist, um ein Ausgangssignal der aktiven Filter/Verstärker-Anordnung (310; 430, 435; 520) zu empfangen;
mindestens eine Rückkopplungsschleife (340, 350; 460, 465, 480, 485; 570, 575, 580, 585, 590, 595), die die passive Filterungsanordnung (320; 440, 445; 530) mit dem Eingangssignal (360, 362, 364) der aktiven Filter/Verstärker-Anordnung (310; 430, 435; 520) verbindet, wobei die Rückkopplungsschleife (340, 350; 460, 465, 480, 485; 570, 575, 580, 585, 590, 595) von der passiven Filterungsanordnung (320; 440, 445; 530) abgegriffen ist;
**dadurch gekennzeichnet, dass** jede Rückkopplungsschleife (340, 350; 460, 465, 480, 485; 570, 575, 580, 585, 590, 595) ein Rückkopplungsschleifen-Widerstandselement (345, 355; 470, 475, 490, 495; 571, 576, 581, 586, 591, 596) umfasst;
und dadurch, dass die passive Filterungsanordnung (320; 440, 445; 530) mindestens zwei schaltbare Widerstandselemente (322, 324; 532, 534, 536, 538, 540, 542, 544, 546, 548, 550, 552, 554, 556, 558, 560, 562, 564, 566) umfasst, wobei die Widerstandselemente (322, 324; 532, 534, 536, 538, 540, 542, 544, 546, 548, 550, 552, 554, 556, 558, 560, 562, 564, 566) in der passiven Filterungsanordnung (320; 440, 445; 530) eine passive Polanordnung mit einem Kapazitätselement (326; 568) bilden, das quer durch die Widerstandselemente (322, 324; 532, 534, 536, 538, 540, 542, 544, 546, 548, 550, 552, 554, 556, 558, 560, 562, 564, 566) verbunden ist.

2. Senderschaltung nach Anspruch 1, wobei die passive Filterungsanordnung (530) eine Anordnung von schaltbaren Widerstandselementen (532, 534, 536, 538, 540, 542, 544, 546, 548, 550, 552, 554, 556, 558, 560, 562, 564, 566) umfasst, wobei das Kapazitätselement (568) quer durch alle schaltbaren Widerstandselemente (532, 534, 536, 538, 540, 542, 544, 546, 548, 550, 552, 554, 556, 558, 560, 562, 564, 566) in der Anordnung verbunden sind, um die passive Polanordnung mit aktiven Widerstandselementen zu bilden.

3. Senderschaltung nach Anspruch 1 oder 2, wobei jedes Rückkopplungsschleifen-Widerstandselement (345, 355; 470, 475, 490, 495; 571, 576, 581, 586, 591, 596) ein schaltbares Widerstandselement umfasst.

4. Senderschaltung nach Anspruch 2 oder 3, wobei jedes schaltbare Widerstandselement (345, 355; 470, 475, 490, 495; 532, 534, 536, 538, 540, 542, 544, 546, 548, 550, 552, 554, 556, 558, 560, 562, 564, 566, 571, 576, 581, 586, 591, 596) ein Schaltelement (534, 540, 548, 552, 558, 566, 574, 579, 584, 589, 594, 599) und mindestens ein Widerstandselement (532, 536, 538, 542, 544, 546, 550, 554, 556, 560, 562, 564, 574, 579, 584, 589, 594, 599) umfasst.

5. Senderschaltung nach einem der vorhergehenden Ansprüche, wobei die Senderschaltung einen Teil einer Sender-Empfängerschaltung bildet.

6. Integrierte Schaltung, die einen Sender-Empfänger nach Anspruch 5 umfasst.

## Revendications

1. Circuit émetteur (300 ; 400 ; 500) comprenant :
un agencement de filtre actif / amplificateur (310 ; 430, 435 ; 520) connecté pour recevoir un signal d'entrée (360 ; 362 ; 364) ; et
un agencement de filtrage passif (320 ; 440, 445 ; 530) connecté pour recevoir un signal de sortie de l'agencement de filtre actif / amplificateur (310 ; 430, 435 ; 520) ;
au moins une boucle de rétroaction (340, 350 ; 460, 465, 480, 485 ; 570, 575, 580, 585, 590, 595) connectant l'agencement de filtrage passif (320 ; 440, 445 ; 530) au signal d'entrée (360 ; 362 ; 364) de l'agencement de filtre actif / amplificateur (310 ; 430, 435 ; 520), la boucle de rétroaction (340, 350 ; 460, 465, 480, 485 ; 570, 575, 580, 585, 590, 595) étant dérivée de l'agencement de filtrage passif (320 ; 440, 445 ; 530) ;
**caractérisé en ce que** chaque boucle de rétroaction (340, 350 ; 460, 465, 480, 485 ; 570, 575, 580, 585, 590, 595) comprend un élément de résistance (345, 355 ; 470, 475, 490, 495 ; 571, 576, 581, 586, 591, 596) de boucle de rétroaction ;
et **en ce que** l'agencement de filtrage passif (320 ; 440, 445 ; 530) comprend au moins deux éléments de résistance commutables (322, 324 ; 532, 534, 536, 538, 540, 542, 544, 546, 548, 550, 552, 554, 556, 558, 560, 562, 564, 566), les éléments de résistance (322, 324 ; 532, 534, 536, 538, 540, 542, 544, 546, 548, 550, 552, 554, 556, 558, 560, 562, 564, 566) dans l'agencement de filtrage passif (320 ; 440, 445 ; 530) formant un agencement de pôle passif avec un élément de capacitance (326 ; 568) connecté sur les éléments de résistance (322, 324 ; 532, 534, 536, 538, 540, 542, 544, 546, 548, 550, 552, 554, 556, 558, 560, 562, 564, 566).

2. Circuit émetteur selon la revendication 1, dans lequel l'agencement de filtrage passif (530) comprend un ensemble d'éléments de résistance commutables (532, 534, 536, 538, 540, 542, 544, 546, 548, 550, 552, 554, 556, 558, 560, 562, 564, 566), l'élément de capacitance (568) étant connecté sur tous les éléments de résistance (532, 534, 536, 538, 540, 542, 544, 546, 548, 550, 552, 554, 556, 558, 560, 562, 564, 566) commutables dans l'ensemble pour former l'agencement de pôle passif avec les éléments de résistance actifs.

3. Circuit émetteur selon la revendication 1 ou 2, dans lequel chaque élément de résistance (345, 355 ; 470, 475, 490, 495 ; 571, 576, 581, 586, 591, 596) de boucle de rétroaction comprend un élément de résistance commutable.

4. Circuit émetteur selon la revendication 2 ou 3, dans lequel chaque élément de résistance commutable (345, 355 ; 470, 475, 490, 495 ; 532, 534, 536, 538, 540, 542, 544, 546, 548, 550, 552, 554, 556, 558, 560, 562, 564, 566, 571, 576, 581, 586, 591, 596) comprend un élément de commutation (534, 540, 548, 552, 558, 566, 574, 579, 584, 589, 594, 599) et au moins un élément de résistance (532, 536, 538, 542, 544, 546, 550, 554, 556, 560, 562, 564, 574, 579, 584, 589, 594, 599).

5. Circuit émetteur selon l'une quelconque des revendications précédentes, dans lequel le circuit émetteur fait partie d'un circuit émetteur-récepteur.

6. Circuit intégré comprenant un émetteur-récepteur selon la revendication 5.
